# FASCICULE DE BREVET EUROPEEN

(11) **EP 3 507 809 B1**
(45) Date de publication et mention de la délivrance du brevet: **14.10.2020**
(21) Numéro de dépôt: 17765108.0
(22) Date de dépôt: 30.08.2017
(51) Int. Cl.: G11C 16/34, G11C 13/00, G11C 7/04, G06F 11/30

(54) **DISPOSITIF ET PROCEDE DE CONTROLE DES CYCLES DE RAFRAICHISSEMENT DES MEMOIRES NON-VOLATILES**
VORRICHTUNG UND VERFAHREN ZUR STEUERUNG VON AKTUALISIERUNGSZYKLEN NICHTFLÜCHTIGER SPEICHER
DEVICE AND METHOD FOR CONTROLLING REFRESH CYCLES OF NON-VOLATILE MEMORIES

(30) Priorité: 01.09.2016 FR 1658135
(43) Date de publication de la demande: 10.07.2019
(73) Titulaire: Commissariat à l'Énergie Atomique et aux Énergies Alternatives, 75015 Paris (FR)
(72) Inventeur: GHERMAN, Valentin, 91120 Palaiseau (FR); SEIF, Marcelino, 91940 Les Ulis (FR)
(74) Mandataire: Marks & Clerk France
(86) Numéro de dépôt international: PCT/EP2017/071749
(87) Numéro de publication internationale: WO 2018/041885

(56) Documents cités:
- US-A1- 2007 211 548
- US-A1- 2010 110 793
- US-A1- 2012 268 995
- US-A1- 2014 101 371
- US-A1- 2014 325 165
- US-A1- 2015 094 995
- US-B1- 6 169 442
- US-B1- 9 165 668

## Description

### Domaine de l'invention

L'invention concerne le domaine des mémoires et s'intéresse en particulier au temps de rétention et au cycle de rafraichissement des données stockées dans les mémoires non-volatiles.

### Etat de la Technique

Les mémoires flash sont des mémoires non-volatiles (MNV) réinscriptibles, dont les données stockées ne disparaissent pas lors d'une mise hors tension. La vitesse élevée, la durée de vie et la faible consommation de ce type de mémoire la rendent attrayante pour de nombreuses utilisations par exemple dans les appareils photo numériques, les téléphones cellulaires, les imprimantes, les assistants personnels (PDA), les ordinateurs portables ou dispositifs de lecture et d'enregistrement sonore comme les baladeurs numériques, les clés USB.

Les disques électroniques connus sous le nom de disques (SSD) de l'anglais « Solid-State Drive », destinés à remplacer les disques durs traditionnels connus sous le nom de disques (HDD) de l'anglais « Hard-Disk Drive » sont des unités de stockage statiques. Certains SSDs utilisent des mémoires flash de type (MLC) de l'anglais « Multi Level Cell » permettant de stocker 2 bits par cellule mémoire ou de type (TLC) de l'anglais « Triple Level Cell » permettant de stocker 3 bits par cellule mémoire au lieu de 1 bit par cellule mémoire comme dans les mémoires flash de type (SLC) de l'anglais « Single Level Cell ». L'augmentation du nombre de bits par cellule est un des moyens de réduction de la différence de prix par gigaoctet (GB) entre les SSDs et les disques durs HDDs, permettant de tirer profit des avantages des SSDs par rapport aux HDDs en termes de performance, consommation et de résistance aux chocs.

Cependant, un point de faiblesse des mémoires flash est que le temps de rétention des données stockées dans les cellules mémoire, temps correspondant à la plus longue période de conservation de données, est impacté par la température régnant dans la mémoire. Ce phénomène est renforcé dans le cas où plus d'un bit est stocké par cellule. Certaines mémoires MLC peuvent avoir un temps de rétention garanti en fin de vie de deux mois à 40°C. Ce temps, par application de la loi d'Arrhenius, qui prédit une augmentation exponentielle du temps de rétention avec la température, équivaut à un temps de rétention de deux jours à 70°C. Or, un SSD avec une charge de travail importante peut raisonnablement atteindre une telle température, même dans un environnement de température contrôlé comme un centre de données (datacenter).

Pour estomper les effets de la réduction du temps de rétention, il est connu de faire un rafraîchissement périodique des données. Ce rafraîchissement peut être exécuté sans changer le lieu où les données sont stockées, en injectant juste la quantité de charge qui manque sur la grille flottante des cellules mémoires et on parle alors de rafraichissement sur place, ou alternativement le rafraichissement peut être fait par réécriture en reprogrammant les données à une adresse différente. Le rafraîchissement sur place se traduit par un impact plus réduit sur la consommation d'énergie et la vitesse de réponse, et il n'a, virtuellement, pas d'impact sur l'endurance aux cycles de P/E.

L'endurance d'une mémoire flash qui est généralement mesurée en nombre de cycles de Programmation/Effacement (P/E) garantis, est réduite d'une décade en moyenne pour chaque bit supplémentaire stocké dans les cellules mémoires. Cet impact peut être mitigé en relaxant la limite supérieure du nombre de cycles de P/E garantis, mais cela vient au détriment du temps de rétention garanti.

Du fait de cette interdépendance mutuelle entre l'endurance et le temps de rétention des mémoires flash, les solutions de rafraîchissement périodique des données peuvent être aussi utilisées pour améliorer l'endurance des mémoires. Ceci peut être mis en œuvre en augmentant le nombre maximal des cycles de P/E permis sur une mémoire flash tout en mitigeant l'impact de cette augmentation par des rafraîchissements périodiques.

L'inconvénient reste qu'en présence de variations de température qui peuvent être dues à un changement des conditions environnementales et/ou dues à la charge de travail de la mémoire, un rafraîchissement à fréquence fixe peut entraîner des pénalités importantes en termes de latence de réponse, de consommation d'énergie et de nombre disponible de cycles de P/E.

Le document US9165668B1 divulgue une méthode à contrôler la température d'un SSD.

Aussi, il existe le besoin d'une solution qui palie aux inconvénients des approches connues. La présente invention répond à ce besoin.

### Résumé de l'invention

Un objet de la présente invention est de proposer un dispositif permettant de suivre l'évolution de l'impact de la température sur le temps de rétention des mémoires non-volatiles réinscriptibles.

Un autre objet de l'invention est de proposer un dispositif permettant d'adapter la fréquence de rafraichissement des mémoires non-volatiles réinscriptibles selon l'évolution de l'impact de la température sur le temps de rétention.

Le dispositif de l'invention est d'une manière générale constitué d'un capteur de température apte à mesurer la température, d'une ou plusieurs mémoires non-volatiles réinscriptibles et d'un module de contrôle apte à faire un suivi de l'impact de l'évolution de la température mesurée sur le temps de rétention des données.

Dans un mode de réalisation, le dispositif de l'invention comprend des moyens permettant de générer une alerte lors de la détection de l'imminence d'une perte de données.

Le dispositif de l'invention permet de déclencher un rafraichissement des données de manière appropriée, lié à l'imminence d'une perte de données, et non de manière systématique et périodique. Le nombre de cycles de rafraichissement des mémoires non-volatiles réinscriptibles est ainsi diminué significativement.

La présente invention trouvera une application avantageuse dans tous les environnements utilisant de manière intensive des mémoires non-volatiles soumises à des hautes températures, tel que par exemple les SSDs utilisés dans les centres de données.

Pour obtenir les résultats recherchés, un dispositif et un procédé tels que revendiqués sont proposés.

L'invention peut opérer sous la forme d'un produit programme qui comprend des instructions de code permettant d'effectuer les étapes du procédé revendiqué lorsque le programme est exécuté sur un micro-processeur.

### Description des figures

Différents aspects et avantages de l'invention vont apparaitre en appui de la description d'un mode préféré d'implémentation de l'invention mais non limitatif, avec référence aux figures ci-dessous :
La figure 1 est un schéma bloc d'un système de communication hôte-disque SSD ou carte mémoire permettant d'implémenter le dispositif de l'invention;
La figure 2 illustre un premier mode de réalisation du dispositif de l'invention ;
La figure 3 illustre une variante de réalisation du dispositif de l'invention;
La figure 4 montre un enchaînement d'étapes pour générer une alerte selon un mode opératoire du dispositif de l'invention ;
La figure 5 illustre sur un axe temporel la génération de plusieurs signaux d'alerte qui sont suivis ou non d'un rafraichissement de données.

### Description détaillée de l'invention

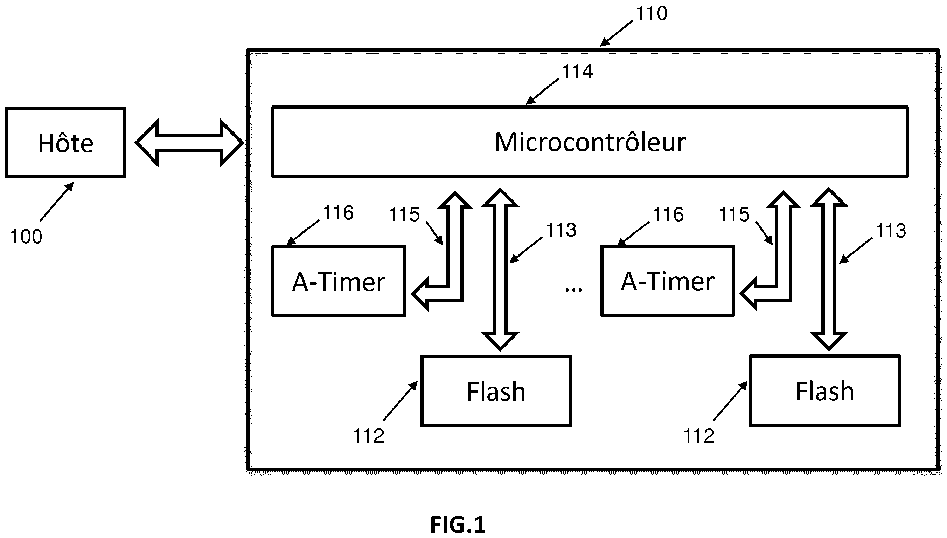

Référence est faite à la figure 1 qui montre de manière schématique un système de communication entre un hôte 100 et un disque SSD ou une carte mémoire 110. Dans l'exemple décrit, le disque SSD 110 est représenté comme comprenant une pluralité de mémoires flash 112. Dans une variante d'implémentation, une seule mémoire flash est connectée à un hôte. La carte 110 comprend des interfaces de connexion pour se connecter avec l'hôte. De manière bien connue de l'homme du métier, de telles interfaces pour des cartes externes peuvent être des connecteurs de type (USB) de l'anglais « Universal System Bus » ou encore de type (SATA) de l'anglais « Serial Advanced Technology Attachment » (non montrées). La carte mémoire 110 peut ainsi se connecter via le connecteur à l'interface correspondante de l'hôte 100 pour échanger des données selon différents protocoles, tels que les protocoles USB, SATA ou d'autres protocoles plus spécifiques de l'hôte. Dans une variante, la carte mémoire 110 peut être une carte embarquée d'un système hôte, l'hôte pouvant accueillir une ou plusieurs cartes mémoires. Selon un autre mode d'implémentation, l'hôte 100 et la carte mémoire 110 sont en communication sans fil et échangent selon des protocoles (Wi-Fi) de l'anglais « Wireless Fidelity ».

L'hôte peut être tout système qui peut utiliser une carte mémoire, un disque SSD ou échanger des données avec une mémoire flash. Ainsi, sans constituer une limitation, l'hôte 100 peut être un ordinateur personnel, fixe ou portable, incluant les tablettes, les téléphones portables, les Smartphones ou autres assistants personnels. L'hôte peut aussi être un serveur et comprendre des réceptacles pour accueillir une ou plusieurs cartes mémoire ou disques SSD.

Le disque SSD 110 comprend un circuit de contrôle 114 comprenant des composants bien connus de l'homme du métier permettant de gérer les échanges de données et instructions entre les mémoires flash 112 et l'hôte 100 via les interfaces de communication hôte/mémoires, de gérer les opérations de lecture/écriture et de rafraichissement des données dans les mémoires flash. Le contrôleur 114 est couplé aux mémoires flash 112 via des bus ou canaux de communication 113, un bus pouvant être connecté à plusieurs mémoires flash. Les mémoires flash 112 peuvent être des mémoires de type SLC et/ou MLC et/ou TLC.

Dans un mode de réalisation, l'ensemble des composants du circuit de contrôle 114 peut être implémenté comme un module dédié tel qu'un (ASIC) de l'anglais « Application Specific Integrated Circuit ».

Selon l'invention, le disque SSD 110 comprend au moins un dispositif 116, désigné par la suite « A-Timer », permettant de suivre l'impact de la température du disque SSD 110 sur le temps de rétention dans les mémoires flash. Dans l'exemple décrit en figure 1, un dispositif A-Timer 116 est associé à chaque mémoire flash.

Dans une variante d'implémentation, un seul dispositif A-Timer 116 peut être associé à un ensemble de mémoires flash qui sont couplées par un même bus de communication et qui présentent une répartition homogène de leur température interne.

Selon une autre variante, quand la température est homogène à travers toutes les mémoires flash, le disque SSD 110 peut comprendre un seul dispositif A-Timer 116.

Selon un mode d'implémentation, si le disque SSD 110 présente des régions où la température est différente, un dispositif A-Timer 116 est assigné au groupe de mémoires flash situées dans chaque région.

Le découpage des régions sur un disque SSD peut se faire sur la base de mesures de température préliminaires réalisées sur le disque ou être repris d'un découpage appliqué sur des versions précédentes du disque 110.

Chaque dispositif A-Timer 116 communique avec le circuit de contrôle 114 via un bus de communication 115. Le circuit de contrôle 114 est responsable de la gestion des dispositifs A-Timer et des échanges avec la ou les mémoires flash respectivement associées.

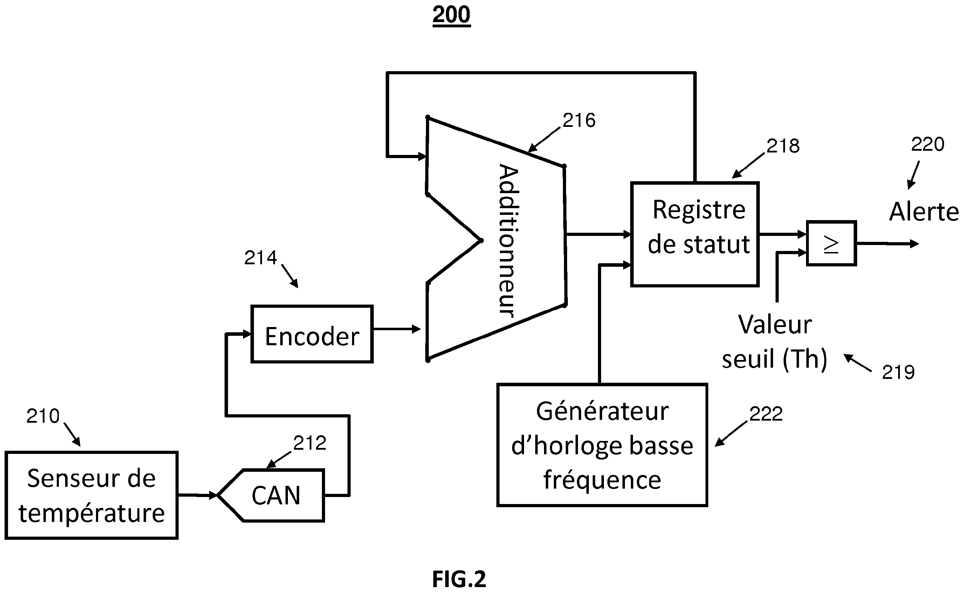

La figure 2 montre un premier mode de réalisation du dispositif A-Timer de l'invention. Le dispositif A-Timer comprend :
- un capteur de température 210 permettant de mesurer la température d'une ou plusieurs mémoires flash ;
- un convertisseur analogique-numérique (CAN) 212 permettant de transformer le signal fourni par le capteur de température en une valeur numérique;
- un encodeur 214 permettant d'encoder la valeur numérique fournie par le CAN dans une valeur numérique qui est proportionnelle à l'impact de la température instantanée sur le temps de rétention des mémoires contrôlées ;
- un additionneur 216 permettant d'ajouter la valeur numérique générée par l'encodeur à une valeur stockée dans un registre de statut 218;
- un registre de statut 218 permettant via l'additionneur d'accumuler dans le temps les valeurs générées par l'encodeur 214 et apte à générer un signal d'alerte 220 quand la valeur stockée dans le registre de statut est augmentée d'un montant qui dépasse un seuil prédéfini (219) ; et
- un générateur de signal d'horloge 222 permettant de cadencer les mises-à-jour de la valeur stockée dans le registre de statut.

Dans une variante d'implémentation, un amplificateur (non montré) est connecté à la sortie du capteur de température pour amplifier le signal envoyé au convertisseur analogique-numérique (CAN) 212.

Le capteur de température 210 permet de mesurer la température d'une mémoire flash ou d'un groupe de mémoires flash à laquelle/auquel il est assigné et générer un signal électrique proportionnel à la température mesurée. Selon une variante, le capteur de température intègre un convertisseur analogique-numérique 212 et fournit en sortie une valeur numérique représentative de la température mesurée, qui peut être utilisée directement par l'additionneur 216 ou l'encodeur 214.

L'encodeur 214 permet d'encoder la valeur numérique fournie par le CAN 212 pour qu'elle devienne proportionnelle à l'impact de la température sur le temps de rétention des mémoires surveillées par le dispositif.

Dans une autre variante d'implémentation, le convertisseur analogique-numérique (CAN) 212 fournit directement l'entrée de l'additionneur 216. Dans ce cas, c'est le CAN 212 qui transforme la température en la valeur numérique proportionnelle à l'impact de la température sur le temps de rétention.

Selon une implémentation, le CAN 212 est un convertisseur flash ou parallèle, et délivre des valeurs numériques sous la forme d'un code dit « thermomètre ou unaire » selon l'enchainement suivant : « 000...0 », « 100...0 », « 110...0 », « 111...0 », ..., « 111...1 ».

Avantageusement, selon une implémentation, l'encodeur 214 est adapté pour modifier le code thermomètre de manière à délivrer des valeurs qui augmentent d'une façon exponentielle de manière similaire à l'impact de la température sur le temps de rétention des mémoires flash, tel que cela est décrit par le modèle représentant la loi d'Arrhenius.

De manière préférentielle, l'encodeur permet un encodage dit « one-hot » selon l'anglicisme consacré, qui consiste à représenter des états en utilisant pour chaque état une valeur dont la représentation binaire n'a qu'un seul chiffre 1.

Ainsi la sortie du CAN flash est encodée selon une correspondance donnée à titre d'exemple dans la table ci-dessous, où le nombre de bits en sortie du CAN dépend du nombre de fois que le temps de rétention est divisé par deux dans un intervalle de température correspondant à l'application :

| CAN 212 | Encodeur 214 |
|---|---|
| 000 ... 0 | 100 ... 00 |
| 100 ... 0 | 010 ... 00 |
| 110 ... 0 | 001 ... 00 |
| 111 ... 0 | 000 ... 10 |
| ... | ... |
| 111 ... 1 | 000 ... 01 |

Dans cette implémentation, les valeurs en sortie de l'encodeur 214 illustrées dans le tableau ci-dessus sont obtenues en additionnant la valeur « 1 » à la sortie correspondante du CAN 212. Dans cet exemple, la sortie de l'encodeur 214 contient un bit de plus que son entrée.

La sortie de l'encodeur devient une des entrées de l'additionneur 216 qui reçoit aussi en entrée la dernière valeur d'état stockée dans le registre de statut 218.

Avantageusement, comme les valeurs additionnées périodiquement à la valeur stockée dans le registre de statut sont proportionnelles à l'impact de la température instantanée sur le temps de rétention des mémoires flash, l'état du registre de statut est proportionnel à l'impact global de l'évolution de la température sur le temps de rétention.

L'état du registre de statut peut-être lu et utilisé comme une étiquette de temps ou « timestamp » selon l'anglicisme connu, associée à chaque bloc ou à chaque page d'une mémoire flash, et correspondant à la dernière opération de programmation/effacement (P/E). L'étiquette d'un bloc mémoire est stockée lors de la première programmation après une opération d'effacement du bloc.

Le registre de statut 218 est adapté pour générer un signal d'alerte 220 chaque fois que la valeur stockée dans le registre de statut est augmentée d'un montant qui dépasse un seuil prédéfini (219). Ce seuil correspond au temps de rétention minimal des blocs mémoire ou à une fraction de ce temps, par exemple la moitié ou le tiers.

Ainsi, l'émission d'un signal d'alerte 220 par le registre de statut 218 est indicative de l'imminence d'une perte de données dans une mémoire flash qui est surveillée par le capteur de température.

Le signal d'alerte est communiqué au microcontrôleur 114 du disque SSD 110 qui va déterminer pour chaque bloc mémoire si un cycle de rafraichissement des données doit être effectué, en fonction de l'étiquette de temps correspondante.

Dans un mode de réalisation, le stockage dans le registre de statut 218 peut être implémenté avec deux technologies mémoires simultanément : une première mémoire volatile, de type DRAM ou SRAM, et une seconde mémoire non-volatile, de type EEPROM, ou Flash.

La mémoire volatile du registre de statut 218 est mise à jour de manière périodique pendant le fonctionnement de l'A-Timer. A chaque arrêt du système, la valeur stockée dans la mémoire volatile du registre de statut 218 est transférée vers la mémoire non-volatile et à chaque démarrage du système, la valeur stockée en mémoire non-volatile est transférée vers la mémoire volatile.

Les mises à jour de la valeur stockée dans le registre de statut 218 sont cadencées par un générateur d'horloge 222. Dans un mode de réalisation, le générateur d'horloge 222 est un générateur basse fréquence, implémenté comme un diviseur de fréquence dont l'entrée est pilotée par un signal d'horloge système. Dans une variante d'implémentation, le générateur basse fréquence est implémenté comme un oscillateur basse-fréquence, tel que par exemple un circuit de type NE555.

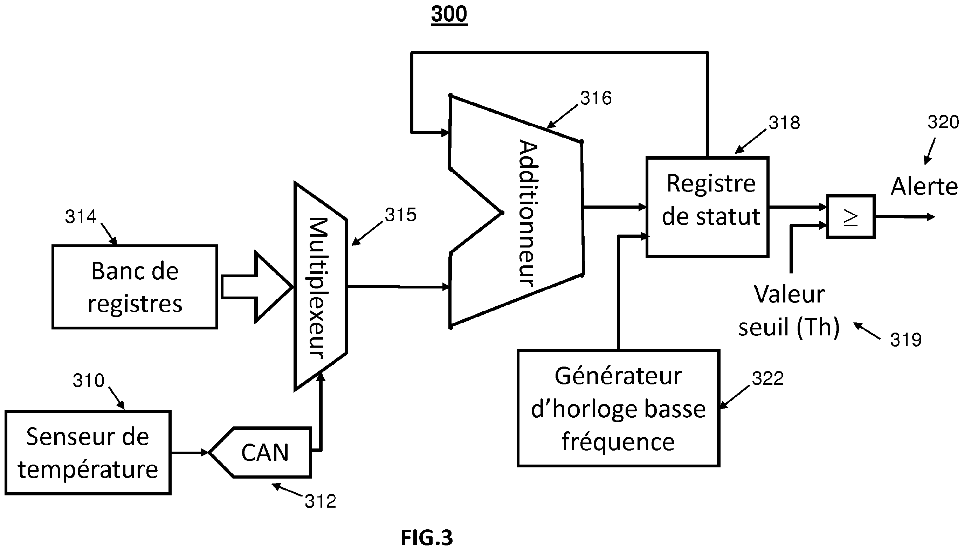

La figure 3 illustre une variante d'implémentation du dispositif de l'invention décrit en figure 2, dans lequel l'encodeur 214 est remplacé par un banc de registres 314 couplé à un multiplexeur 315. Ainsi, le dispositif de la figure 3 comprend un capteur de température 310 couplé à un convertisseur analogique-numérique CAN 312, un additionneur 316, un registre de statut 318 et un générateur d'horloge 322.

La sortie du CAN pilote le multiplexeur 315, qui reçoit en entrée les sorties des registres du banc de registres 314. Selon la valeur délivrée par le CAN, le multiplexeur sélectionne un registre parmi l'ensemble des registres du banc de registres 314. La valeur du registre sélectionné est transférée en entrée de l'additionneur 316. L'additionneur reçoit aussi en entrée la valeur stockée dans le registre de statut.

Le registre de statut 318 est adapté pour générer un signal d'alerte 320 chaque fois qu'une valeur stockée dans le registre de statut est augmentée d'un montant qui dépasse une valeur seuil prédéfinie (319). Ce seuil correspond au temps de rétention minimal du ou des blocs mémoires surveillés, ou à une fraction de ce temps, par exemple la moitié ou le tiers.

Ainsi, l'émission d'un signal d'alerte 320 par le registre de statut 318 est indicative de l'imminence d'une perte de données dans une ou plusieurs mémoires surveillées par le capteur de température.

Chaque registre du banc de registres 314 contient une valeur qui peut être transférée à l'additionneur en fonction de la sortie du CAN. La variante de la figure 3 rend programmable le dispositif de l'invention en permettant de changer les valeurs des registres du banc de registre. Ainsi, avantageusement, à travers le choix des valeurs dans le banc de registres 314, le dispositif de l'invention peut être facilement adapté à d'autres modèles pour décrire l'évolution de la température et l'impact sur le temps de rétention des mémoires flash, comme par exemple un modèle construit par la superposition de plusieurs courbes d'Arrhenius,.

Avantageusement, le dispositif de l'invention peut être adapté pour surveiller d'autres types des mémoires, telles des mémoires résistives ou des mémoires DRAM. Toujours avantageusement, le dispositif de l'invention peut opérer pour des mémoires flash MLC ou TLC de type NAND.

Selon un mode de réalisation, le banc de registres 314 peut être implémenté avec deux technologies de mémoire simultanément: une technologie de mémoire volatile, de type DRAM ou SRAM, et une technologie de mémoire non-volatile, de type ROM, EEPROM ou Flash. En mode opératoire, à chaque démarrage du système, les valeurs adaptées au fonctionnement du dispositif A-Timer selon l'application souhaitée, sont transférées de la zone mémoire non-volatile vers la zone mémoire volatile du banc de registres, où elles peuvent être ensuite sélectionnées selon la valeur délivrée par le CAN 312 pour être envoyées à l'additionneur 316.

Dans une autre variante programmable du dispositif A-Timer, l'ensemble des fonctions de - lecture du CAN, sélection d'une valeur d'incrémentation, ajout à la valeur du registre de statut - est réalisé par un micro-processeur ou un microcontrôleur. Le micro-processeur est adapté pour lire périodiquement la sortie du CAN (ou la sortie du capteur de température dans le cas où il délivre directement une valeur numérique), pour choisir une valeur d'incrémentation en fonction de la valeur en sortie du CAN et pour ajouter cette valeur d'incrémentation à la valeur stockée dans le registre de statut.

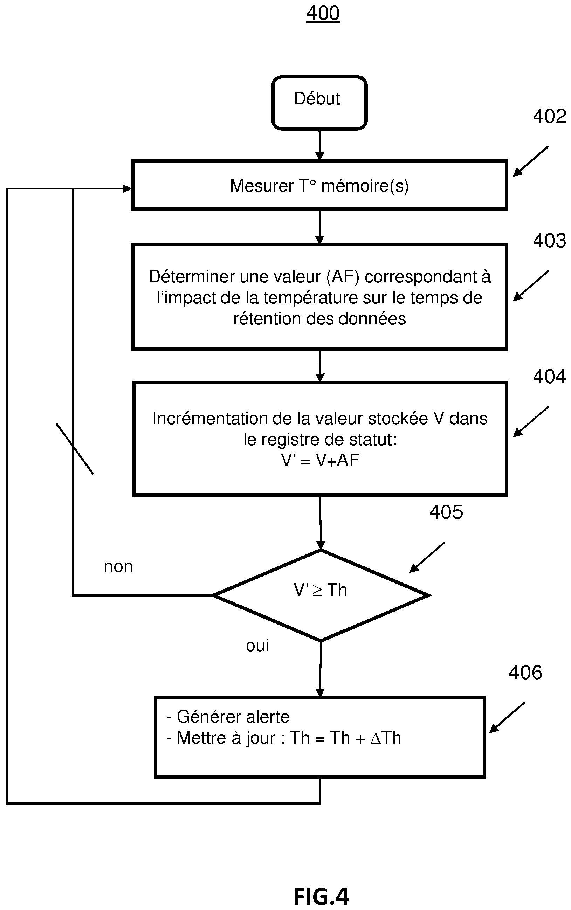

La figure 4 montre un enchainement d'étapes 400 permettant de générer une alerte selon un mode opératoire du dispositif de l'invention. Le procédé 400 débute par une étape 402 de mesure de la température d'une ou plusieurs mémoires. Dans une implémentation préférentielle, la ou les mémoires sont de type mémoire flash et la mesure de température est prise par un capteur de température assigné à la ou aux mémoires flash d'un disque SSD ou d'une carte mémoire 110. Dans les étapes suivantes (403 à 405), le procédé permet de détecter si une perte de données est imminente, et si oui de générer 406 une alerte sinon de reboucler au début.

L'étape de détermination de la perte imminente de données peut être effectuée selon l'une des implémentations du dispositif de l'invention précédemment décrites, où à partir de la valeur de la température mesurée, une valeur (AF) proportionnelle à l'impact de la température instantanée sur le temps de rétention des mémoires est déterminée (403), et additionnée (404) à la dernière valeur (V) stockée dans un registre de statut. La valeur résultante (V') est ensuite comparée (405) à une valeur seuil (Th), pour donner l'indication de l'imminence ou non d'une perte de données. Si la valeur résultante reste en dessous de la valeur seuil, signifiant qu'il n'y a pas de pertes de données imminente, le procédé reboucle au début. Si la valeur résultante est supérieure à la valeur seuil, signifiant qu'une perte de données est imminente dans la mémoire surveillée ou dans l'une des mémoires surveillées, le procédé permet (406) de générer une alerte et de mettre à jour la valeur seuil Th en l'augmentant d'une valeur correspondant au temps de rétention minimal (ou une fraction de ce temps) du ou des blocs mémoires surveillés. Le procédé peut reboucler sur un nouveau cycle.

Avec l'émission du signal d'alerte, le procédé permet d'évaluer le temps de rétention restant pour chaque bloc mémoire dans la ou les mémoires concernées. Selon un mode de réalisation, l'évaluation du temps de rétention restant est faite par un microcontrôleur, tel le microcontrôleur 114 de la carte mémoire 110. Le signal d'alerte généré par le registre de statut d'un A-timer donné est envoyé au microcontrôleur qui évalue le temps de rétention restant pour chaque bloc ou page mémoire de la ou des mémoires ayant des données valides.

Dans un mode de réalisation, le microcontrôleur compare l'état courant du registre de statut de l'A-timer qui a généré l'alerte à l'étiquette de chaque bloc dans les mémoires qui sont surveillées par ce A-timer. Selon une implémentation, l'enregistrement de l'étiquette de chaque bloc mémoire peut se faire après la première page programmée dans un bloc mémoire qui vient d'être effacé.

Si la différence entre l'état courant du registre de statut et l'étiquette d'un bloc mémoire concernée est supérieure à un seuil donné, le procédé permet d'effectuer un cycle de rafraichissement des données dans le bloc mémoire considéré, de passer au bloc mémoire suivant afin de détecter si une perte de données est imminente. Le seuil de déclenchement d'un cycle de rafraichissement des données dépend du nombre de cycles de P/E déjà effectué sur chaque bloc mémoire dans les mémoires concernées.

Ainsi, avantageusement, le dispositif de l'invention permet de fournir des étiquettes indiquant un moment précis dans le temps, et d'identifier les blocs mémoire dont les données stockées doivent être rafraichies.

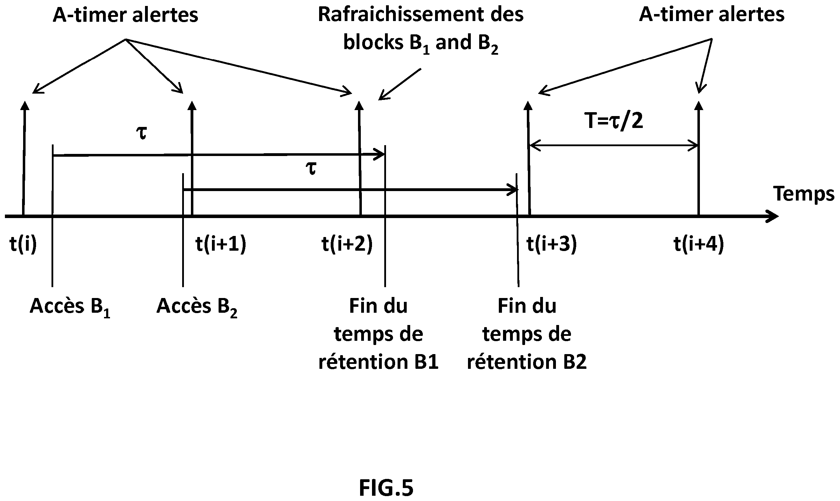

La figure 5 illustre sur un axe temporel la génération de plusieurs signaux d'alerte qui sont suivis ou non d'un rafraichissement de données. Comme décrit précédemment, les états du registre de statut de l'A-timer peuvent être utilisés comme des étiquettes de temps associées à chaque bloc ou à chaque page d'une mémoire non-volatile. Suite à une alerte, le dispositif permet d'évaluer la différence entre l'état courant du registre de statut et l'étiquette de chaque bloc mémoire. Si pour un bloc mémoire, la différence est supérieure à un seuil donné, les données dans le bloc mémoire considéré doivent être rafraichies. Cependant, afin d'éviter que les données de tous les blocs soient rafraichies à chaque génération d'alerte, la période 'T' entre les alertes est choisie pour être plus petite que le temps minimal de rétention des données 'τ'. Sur l'exemple illustré, la période entre les alertes est 'T=τ/2', pour un temps de rétention de deux blocs mémoire (B1, B2) égal à 'τ'. Avec des accès aux deux blocs mémoires programmés entre deux alertes consécutives générées aux temps t(i) et t(i+1), les données doivent être rafraichies juste après l'alerte générée au temps t(i+2). Il est à noter que les données du bloc mémoire B₁ sont rafraichies juste avant que leur temps de rétention soit épuisé, alors que les données du bloc mémoire B₂ sont rafraichies juste après la moitié de leur temps de rétention. Cela illustre que le temps de stockage effectif est plus petit que le temps de rétention d'une valeur comprise entre 0 et T, et justifie l'avantage d'avoir une période T entre les alertes aussi petite que possible. Quand 'T=τ/n', chaque bloc mémoire doit être rafraichi toutes les n alertes. Cela permet aussi de considérer des blocs mémoire avec des états d'usure différents, c'est-à-dire ayant un nombre de cycles P/E et de temps de rétention différents. Ainsi le dispositif de l'invention et son procédé peuvent être appliqués pour surveiller le temps de rétention de tous les blocs d'une ou plusieurs mémoires non-volatiles, même si ces blocs contiennent des données hétérogènes écrites à des moments non-corrélés dans le temps ou si ces blocs ont des niveaux d'usure différents, e.g. nombre de cycles de programmation/effacement (P/E) différents. Certains blocs mémoires pourront être rafraichis toutes les deux alertes, comme montré sur la figure 5, alors que d'autres blocs mémoires pourront être rafraichis toutes les trois ou plus alertes. Avantageusement, le dispositif A-timer permet d'établir une politique de surveillance et de rafraichissement, sur une durée qui englobe plusieurs alertes dû au fait (i) que le registre de statut de l'A-timer est toujours incrémenté sans être jamais remis à zéro et (ii) qu'un signal d'alerte est généré chaque fois que la valeur stockée dans le registre de statut est augmentée d'un montant qui dépasse un seuil prédéfini et recalculé après une génération de signal d'alerte. La présente description illustre une implémentation préférentielle de l'invention, mais n'est pas limitative. Des exemples sont choisis pour permettre une bonne compréhension des principes de l'invention et une application concrète, mais ne sont en rien exhaustifs et doivent permettre à l'homme du métier d'apporter des modifications et variantes d'implémentation en conservant les mêmes principes.

L'invention peut s'implémenter à partir d'éléments matériel et/ou logiciel. Elle peut être disponible en tant que produit programme.

## Revendications

1. Un dispositif (116) pour contrôler les cycles de rafraichissement de données stockées en mémoire non-volatile réinscriptible, ladite mémoire non volatile réinscriptible étant composée d'une pluralité de blocs mémoire, le dispositif comprenant :
- un capteur de température (210) apte à mesurer la température de la mémoire non-volatile réinscriptible et à délivrer une valeur représentative de la température mesurée ; et
- un module de contrôle (200), comprenant un encodeur (214) apte à encoder la valeur représentative de la température mesurée en une valeur encodée proportionnelle à l'impact de la température instantanée sur le temps de rétention dans la mémoire non-volatile réinscriptible ;
le dispositif étant **caractérisé en ce que** le module de contrôle comprend de plus :
- un additionneur (216) couplé à l'encodeur (214) et à un registre de statut (218), l'additionneur recevant en entrée la valeur de sortie de l'encodeur et une dernière valeur d'état stockée dans le registre de statut pour délivrer une valeur résultante, la dernière valeur d'état stockée dans le registre de statut correspondant à l'accumulation de valeurs encodées précédemment de sorte que l'état du registre de statut est proportionnel à l'impact global de l'évolution de la température sur le temps de rétention ;
et **en ce que** le registre de statut est couplé à un microcontrôleur (114), pour déterminer si la valeur résultante est augmentée d'un montant supérieur à une valeur seuil prédéfinie, ladite valeur seuil correspondant au temps ou à une fraction du temps de rétention minimal des blocs mémoire; et pour :
- revenir à l'étape de mesure de température, si la valeur résultante est augmentée d'un montant inférieur à la valeur seuil prédéfinie ; ou
- si la valeur résultante est augmentée d'un montant supérieur ou égal à la valeur seuil prédéfinie :
- générer un signal d'alerte de perte de données imminente ;
- évaluer le temps de rétention restant pour chaque bloc mémoire de la mémoire non-volatile réinscriptible ; et
- selon le résultat pour chaque bloc mémoire, opérer ou non un rafraichissement des données dudit bloc mémoire, et revenir à l'étape de mesure de température.

2. Le dispositif selon la revendication 1 dans lequel le module de contrôle (200) comprend :
- un banc de registres (314) apte à stocker des valeurs représentatives d'une modélisation de l'évolution du temps de rétention des données en fonction de la température ;
- un multiplexeur (315) couplé au banc de registres, apte à sélectionner en fonction de l'information de température délivrée par le capteur de température un registre dans le banc de registres et délivrer la valeur stockée dans ledit registre ; et
- un additionneur (316) couplé au multiplexeur et au registre de statut, l'additionneur recevant en entrée la valeur en sortie du multiplexeur et la dernière valeur d'état du registre de statut.

3. Le dispositif selon les revendications 1 ou 2 dans lequel le temps de rétention restant est calculé en fonction du nombre de cycles de programmation/effacement effectués pour ledit bloc.

4. Le dispositif selon l'une quelconque des revendications 1 à 3 dans lequel la modélisation de l'évolution du temps de rétention des données en fonction de la température est basée sur la loi d'Arrhenius.

5. Le dispositif selon l'une quelconque des revendications 1 à 4 dans lequel le capteur de température (210) est couplé à un convertisseur analogique-numérique (212), et l'information de température est une valeur numérique délivrée par le convertisseur analogique-numérique.

6. Le dispositif selon la revendication 5 dans lequel le convertisseur analogique-numérique (212) est un convertisseur apte à délivrer des valeurs numériques sous la forme d'un code « thermomètre ».

7. Le dispositif selon l'une quelconque des revendications 1 à 6 dans lequel le module de contrôle comprend de plus un générateur d'horloge (222).

8. Le dispositif selon la revendication 7 dans lequel le générateur d'horloge (222) est couplé au registre de statut (218) pour cadencer les mises-à-jour de la valeur stockée dans le registre de statut.

9. Un disque SSD ou une carte mémoire comprenant un microcontrôleur et une pluralité de mémoires non-volatiles, le disque SSD ou la carte mémoire comprenant de plus un ou plusieurs dispositifs selon l'une quelconque des revendications 1 à 8 pour contrôler le cycle de rafraichissement des données de la pluralité des mémoires non-volatiles réinscriptibles.

10. Le dispositif selon l'une quelconque des revendications 1 à 9 dans lequel ladite au moins une mémoire non-volatile réinscriptible est une mémoire flash.

11. Un procédé (400) pour contrôler les cycles de rafraichissement de données stockées en mémoire non-volatile réinscriptible, ladite mémoire non volatile réinscriptible étant composée d'une pluralité de blocs mémoire, le procédé comprenant les étapes de
- mesurer (402) la température de la mémoire non volatile réinscriptible et délivrer une valeur représentative de la température mesurée ;
- utiliser (403) la valeur représentative de la température mesurée avec une modélisation de l'impact de la température sur le temps de rétention des données pour encoder ladite valeur en une valeur encodée proportionnelle à l'impact de la température instantanée sur le temps de rétention dans la mémoire non-volatile réinscriptible;
- additionner (404) ladite valeur encodée à une dernière valeur d'état stockée dans un registre de statut pour obtenir une valeur résultante, la dernière valeur d'état stockée dans le registre de statut correspondant à l'accumulation de valeurs encodées précédemment, de sorte que l'état du registre de statut est proportionnel à l'impact global de l'évolution de la température sur le temps de rétention ;
- déterminer (405) si la valeur résultante est augmentée d'un montant supérieur à une valeur seuil prédéfinie, ladite valeur seuil correspond au temps ou à une fraction du temps de rétention minimal de la pluralité des blocs mémoire; et
- si la valeur résultante est augmentée d'un montant inférieur à la valeur seuil prédéfinie, revenir à l'étape de mesure de température (402) ; ou
- si la valeur résultante est augmentée d'un montant supérieur ou égal à la valeur seuil prédéfinie (406) :
- générer un signal d'alerte de perte de données imminente ;
- évaluer le temps de rétention restant pour chaque bloc mémoire de la mémoire non-volatile réinscriptible ; et
- selon le résultat pour chaque bloc mémoire, opérer ou non un rafraichissement des données dudit bloc mémoire, et revenir à l'étape de mesure de température.

12. Le procédé selon la revendication 11 comprenant après la génération d'un signal d'alerte, une étape de mettre à jour la valeur seuil.

13. Un produit programme, ledit programme comprenant des instructions de code permettant d'effectuer les étapes du procédé selon les revendications 11 ou 12, lorsque ledit programme est exécuté sur un micro-processeur.

## Patentansprüche

1. Vorrichtung (116) zum Steuern von Auffrischzyklen für Daten, die in einem nichtflüchtigen, wiederbeschreibbaren Speicher gespeichert sind, wobei der nichtflüchtige, wiederbeschreibbare Speicher aus mehreren Speicherblöcken zusammengesetzt ist, wobei die Vorrichtung Folgendes umfasst:
- einen Temperatursensor (210) zum Messen der Temperatur des wiederbeschreibbaren, nichtflüchtigen Speichers und zum Liefern eines für die gemessene Temperatur repräsentativen Wertes; und
- ein Steuermodul (200) mit einem Encoder (214) zum Encodieren des repräsentativen Wertes der gemessenen Temperatur in einen encodierten Wert proportional zum Einfluss der momentanen Temperatur auf die Retentionszeit in dem nichtflüchtigen, wiederbeschreibbaren Speicher;
wobei die Vorrichtung **dadurch gekennzeichnet ist, dass** das Steuermodul ferner Folgendes umfasst:
- einen Addierer (216), der mit dem Encoder (214) und einem Statusregister (218) gekoppelt ist, wobei der Addierer am Eingang den Ausgangswert des Encoders und einen letzten im Statusregister gespeicherten Statuswert empfängt, um einen resultierenden Wert zu liefern, wobei der letzte im Statusregister gespeicherte Zustandswert der Akkumulation von zuvor encodierten Werten entspricht, so dass der Zustand des Statusregisters proportional zum Gesamteinfluss des Temperaturverlaufs auf die Retentionszeit ist;
und dadurch, dass das Statusregister mit einem Mikrocontroller (114) gekoppelt ist, um festzustellen, ob der resultierende Wert um einen Betrag erhöht wird, der größer als ein vordefinierter Schwellenwert ist, wobei der Schwellenwert der Zeit oder einem Bruchteil der Mindestretentionszeit der Speicherblöcke entspricht; und zum:
- Zurückkehren zum Temperaturmessschritt, wenn der resultierende Wert um einen Betrag erhöht wird, der kleiner ist als der vordefinierte Schwellenwert; oder
- wenn der resultierende Wert um einen Betrag erhöht wird, der gleich dem oder größer als der vordefinierte(n) Schwellenwert ist:
- Erzeugen eines Warnsignals vor drohendem Datenverlust;
- Beurteilen der verbleibenden Retentionszeit für jeden Speicherblock des wiederbeschreibbaren, nichtflüchtigen Speichers; und
- Durchführen, je nach dem Ergebnis für jeden Speicherblock, einer Auffrischung der Daten des Speicherblocks oder nicht, und Zurückkehren zum Temperaturmessschritt.

2. Vorrichtung nach Anspruch 1, wobei das Steuermodul (200) Folgendes umfasst:
- eine Registerbank (314) zum Speichern von Werten, die für eine Modellierung des Verlaufs der Datenretentionszeit in Abhängigkeit von der Temperatur repräsentativ sind;
- einen mit der Registerbank gekoppelten Multiplexer (315), der in Abhängigkeit von der vom Temperatursensor gelieferten Temperaturinformation ein Register in der Registerbank auswählen und den in diesem Register gespeicherten Wert liefern kann; und
- einen mit dem Multiplexer und dem Statusregister gekoppelten Addierer (316), wobei der Addierer am Eingang den Ausgangswert des Multiplexers und den letzten Zustandswert des Statusregisters empfängt.

3. Vorrichtung nach Anspruch 1 oder 2, bei der die verbleibende Retentionszeit in Abhängigkeit von der Anzahl der für den Block durchgeführten Programmier- /Löschzyklen berechnet wird.

4. Vorrichtung nach einem der Ansprüche 1 bis 3, bei der die Modellierung des Verlaufs der Datenretentionszeit in Abhängigkeit von der Temperatur auf dem Arrhenius-Gesetz basiert.

5. Vorrichtung nach einem der Ansprüche 1 bis 4, bei der der Temperatursensor (210) mit einem Analog-Digital-Wandler (212) gekoppelt ist und die Temperaturinformation ein vom Analog-Digital-Wandler (212) ausgegebener digitaler Wert ist.

6. Vorrichtung nach Anspruch 5, wobei der Analog-Digital-Wandler (212) ein Wandler ist, der digitale Werte in Form eines "Thermometer"-Codes liefern kann.

7. Vorrichtung nach einem der Ansprüche 1 bis 6, wobei das Steuermodul ferner einen Taktgenerator (222) umfasst.

8. Vorrichtung nach Anspruch 7, wobei der Taktgenerator (222) mit dem Statusregister (218) gekoppelt ist, um Aktualisierungen des im Statusregister gespeicherten Wertes zu takten.

9. SSD-Platte oder Speicherkarte mit einem Mikrocontroller und mehreren nichtflüchtigen Speichern, wobei die SSD-Platte oder Speicherkarte ferner eine oder mehrere Vorrichtungen nach einem der Ansprüche 1 bis 8 zur Steuerung des Datenauffrischungszyklus der mehreren wiederbeschreibbaren, nichtflüchtigen Speicher aufweist.

10. Vorrichtung nach einem der Ansprüche 1 bis 9, bei der der mindestens eine wiederbeschreibbare, nichtflüchtige Speicher ein Flash-Speicher ist.

11. Verfahren (400) zum Steuern der Auffrischzyklen für Daten, die in einem nichtflüchtigen, wiederbeschreibbaren Speicher gespeichert sind, wobei der nichtflüchtige, wiederbeschreibbare Speicher aus mehreren Speicherblöcken zusammengesetzt ist,
- Messen (402) der Temperatur des wiederbeschreibbaren, nichtflüchtigen Speichers und Liefern eines für die gemessene Temperatur repräsentativen Wertes;
- Benutzen (403) des gemessenen, für die Temperatur repräsentativen Wertes mit einer Modellierung des Einflusses der Temperatur auf die Datenretentionszeit, um diesen Wert in einen encodierten Wert proportional zum Einfluss der momentanen Temperatur auf die Retentionszeit im wiederbeschreibbaren, nichtflüchtigen Speicher zu encodieren;
- Addieren (404) des encodierten Wertes zu einem letzten Zustandswert, der in einem Statusregister gespeichert ist, um einen resultierenden Wert zu erhalten, wobei der letzte im Statusregister gespeicherte Zustandswert der Akkumulation von zuvor encodierten Werten entspricht, so dass der Zustand des Statusregisters proportional zur Gesamtauswirkung der Temperaturentwicklung auf die Retentionszeit ist;
- Feststellen (405), ob der resultierende Wert um einen Betrag erhöht wird, der um einen vordefinierten Schwellenwert größer ist, wobei der Schwellenwert der Zeit oder einem Bruchteil der Mindestretentionszeit der mehreren Speicherblöcke entspricht; und
- Zurückkehren zum Temperaturmessschritt (402), wenn der resultierende Wert um einen geringeren Betrag als den voreingestellten Schwellenwert erhöht wird; oder
- wenn der resultierende Wert um einen Betrag erhöht wird, der gleich dem oder größer der vordefinierte(n) Schwellenwert (406) ist:
- Erzeugen eines Warnsignals vor drohendem Datenverlust;
- Beurteilen der verbleibenden Retentionszeit für jeden Block des nichtflüchtigen, wiederbeschreibbaren Speichers; und
- Durchführen, je nach dem Ergebnis für jeden Speicherblock, einer Auffrischung der Daten des Speicherblocks oder nicht, und Zurückkehren zum Temperaturmessschritt.

12. Verfahren nach Anspruch 11, das nach dem Erzeugen eines Warnsignals einen Schritt des Aktualisierens des Schwellenwertes beinhaltet.

13. Programmprodukt, wobei das Programm Codebefehle zur Durchführung der Verfahrensschritte nach Anspruch 11 oder 12 enthält, wenn das Programm auf einem Mikroprozessor ausgeführt wird.

## Claims

1. A device (116) for controlling the cycles for refreshing data stored in rewritable non-volatile memory, said rewritable non-volatile memory being composed of a plurality of memory blocks, the device comprising:
- a temperature sensor (210) adapted to measure the temperature of the rewritable non-volatile memory and to provide a value representative of the measured temperature; and
- a control module (200), comprising an encoder (214) adapted to encode the value representative of the measured temperature into an encoded value proportional to the impact of the instantaneous temperature on the retention time in the rewritable non-volatile memory;
the device being **characterized in that** the control module further comprises:
- an adder (216) coupled to the encoder (214) and to a status register (218), the adder receiving as input the output value of the encoder and a last state value stored in the status register in order to provide a resultant value, the last state value stored in the status register corresponding to the accumulation of previously encoded values such that the state of the status register is proportional to the global impact of the evolution of the temperature on the retention time;
and **in that** the status register is coupled to a microcontroller (114) to determine if the resultant value is increased by an amount which is higher than a predefined threshold value, said threshold value corresponding to the time or a fraction of the minimal retention time of the memory blocks; and to:
- return to the temperature measuring step, if the resultant value is increased by an amount which is lower than the predefined threshold value; or
- if the resultant value is increased by an amount which is higher than or equal to the predefined threshold value:
- generate an alert signal warning of imminent loss of data;
- evaluate the retention time remaining for each block of the rewritable non-volatile memory; and
- according to the result for each memory block, operate or not a refresh of the data in said memory block and return to the temperature measuring step.

2. The device according to claim 1, wherein the control module (200) comprises:
- a bank of registers (314) adapted to store values representative of a modeling of the evolution of the data retention time as a function of temperature;
- a multiplexer (315) coupled to the bank of registers, adapted to select as a function of the item of temperature information delivered by the temperature sensor a register in the bank of registers and delivering the value stored in said register; and
- an adder (316) coupled to the multiplexer and to a status register, the adder receiving as input the value output by the multiplexer and the last state value of the status register.

3. The device according to claims 1 or 2, wherein the remaining retention time is calculated as a function of the number of programming/erasure cycles performed for said block.

4. The device according to any one of claims 1 to 3, wherein the modeling of the evolution of the data retention time as a function of temperature is based on the Arrhenius law.

5. The device according to any one of claims 1 to 4, wherein the temperature sensor (210) is coupled to an analog-digital converter (212), and the item of temperature information is a numerical value provided by the analog-digital converter.

6. The device according to claim 5, wherein the analog-digital converter (212) is a converter adapted to provide numerical values in the form of a "thermometer" code.

7. The device according to any one of claims 1 to 6, wherein the control module moreover comprises a clock generator (222).

8. The device according to claim 7, wherein the clock generator (222) is coupled to the status register (218) so as to regulate the updates of the value stored in the status register.

9. An SSD disk or a memory card comprising a microcontroller and a plurality of non-volatile memories, the SSD disk or the memory card further comprising at least one or several devices according to any one of claims 1 to 8 for controlling data refresh cycles of the plurality of the rewritable non-volatile memories.

10. The device according to any one of claims 1 to 9, wherein said at least one rewritable non-volatile memory is a flash memory.

11. A method (400) for controlling the refresh cycles for refreshing data stored in rewritable non-volatile memory, said rewritable non-volatile memory being composed of a plurality of memory blocks, the method comprising the steps of:
- measuring (402) the temperature of the rewritable non-volatile memory, and providing a value representative of the measured temperature;
- using (403) the value representative of the measured temperature with a modeling of the impact of the temperature on the data retention time to encode said value in a proportional encoded value at the impact of the immediate temperature on the retention time in the rewritable non-volatile memory;
- adding (404) said encoded value to a last state value stored in a status register in order to obtain a resultant value, the last state value stored in the status register corresponding to the accumulation of previously encoded values such that the state of the status register is proportional to the global impact of the evolution of the temperature on the retention time;
- determining (405) whether the resulting value is increased by an amount which is higher than a predefined threshold value, said threshold value corresponding to the time or a fraction of the minimal retention time of the plurality of memory blocks; and
- if the resultant value is increased by an amount which is higher than or equal to the predefined threshold value (406):
- generate an alert signal warning of imminent loss of data;
- evaluate the retention time remaining in each block of the rewritable non-volatile memory; and
- according to the result for each memory block, operate or not a refresh of the data in said memory block and return to the temperature measuring step.

12. The method according to claim 11, further comprising, after generating an alert signal, a step of updating the threshold value.

13. A program product, said program comprising code instructions for performing the steps of the method according to claim 11 or 12, when said program is executed on a micro-processor.
